Europäisches Patentamt

European Patent Office

Office européen des brevets

(11) Publication number: **0 317 191**
**A2**

# EUROPEAN PATENT APPLICATION

(21) Application number: 88310641.1

(22) Date of filing: 11.11.88

(51) Int. Cl.⁴: **G01R 1/073**

(30) Priority: 13.11.87 JP 173633/87

(43) Date of publication of application:
**24.05.89 Bulletin 89/21**

(84) Designated Contracting States:
**DE FR GB IT**

(71) Applicant: **Hewlett-Packard Company**
**3000 Hanover Street**
**Palo Alto California 94304(US)**

(72) Inventor: **Shimo Kazuo**
**448-2 Ina, Ituskaichimachi**
**Nishitamegun, Tokyo(JP)**
Inventor: **Nagakusa Keiichi**
**3-32-10, Minami, Kohenji**
**Suginamiku, Tokyo(JP)**

(74) Representative: **Colgan, Stephen James et al**
**CARPMAELS & RANSFORD 43 Bloomsbury**
**Square**
**London WC1A 2RA(GB)**

(54) **Terminal connection device.**

(57) A terminal connection device including a plurality of contacts (31,32), each of which has a spring loaded contact probe (31a,32a) which is adapted to be pressed against a test terminal corresponding thereto to transmit a signal. A housing (30) has a plurality of holes (55,56) therethrough for holding the contacts (31,32). Each hole (55,56) has a slot (33,34) along its length opening through a side of the metal housing (30). The axes of the holes (55,56), the slots (33,34) and the sides of the housing (30) are parallel to permit extrusion of the housing blank from which the housings (30) are cut. Each of said contacts (31,32) is secured substantially at the center of each of said holes (55,56), some contacts (31) being co-axial conductors and others (32) being common or ground conductors.

**Fig. 3**

# TERMINAL CONNECTION DEVICE

## Background of the Invention

### 1. Field of the Invention

This invention relates to a terminal connection device and, more particularly, to a terminal connection device, usable with a testing apparatus for testing semiconductor devices and the like, which detachably connects a plurality of high-speed signal lines at a time.

### 2. Description of the Prior Art

In the field of testing apparatuses such as semiconductor integrated circuit testing apparatuses, a measuring instrument and a device under test such as semiconductor devices are connected to each other by a very large number of test signal lines. When testing a different type of device, the wiring pattern of these signal lines to the device under test much be changed. To avoid such troublesome work, there are prepared, with respect to each of different types of devices under test, a printed circuit board having a different pattern of wiring and a socket for detachably setting the device to be tested. Thus, the wiring pattern of these signal lines to the circuit board is not required to be changed. A terminal connection device is used to easily connect and disconnect the circuit board and the wiring pattern of the signal lines.

Recently, the number of input/output pins or terminals of the devices under test has been increasing and the number of signals required for testing is also increasing correspondingly. Thus, the terminal connection device becomes more important and high-precision and high-speed signal transmission characteristics are demanded in compliance with the desired characteristics of signals passing through the terminal connection device.

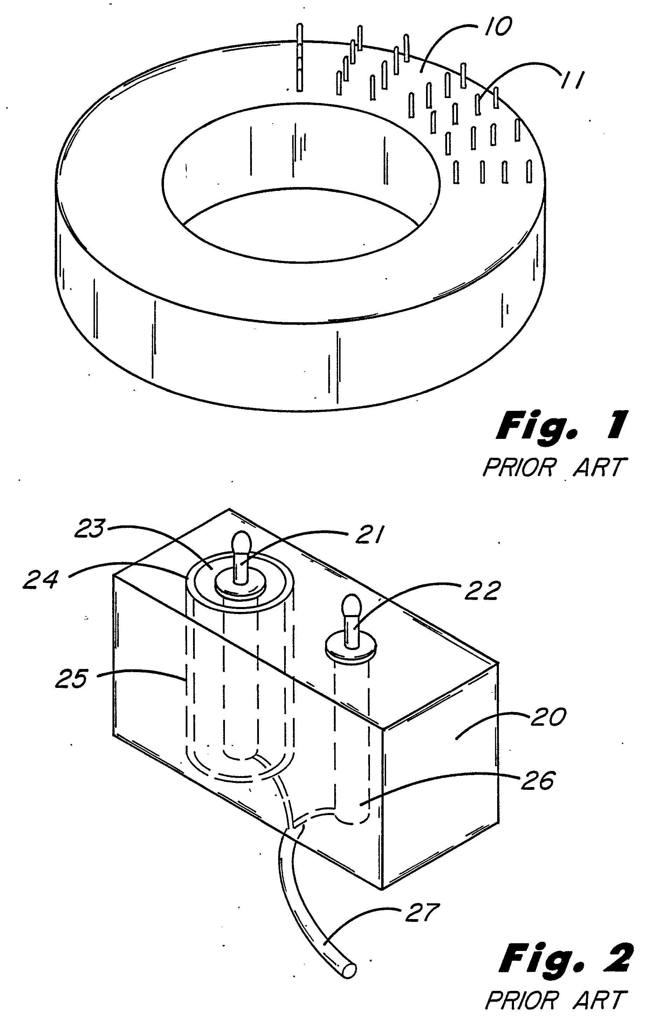

A conventional connection device, as shown in prior art Fig. 1, includes a plurality of contacts 11, each having a retractable projecting spring-loaded contact pin or probe. The contacts 11 are disposed in an annular insulating housing 10. A printed circuit board (not shown) having terminal patterns corresponding to the pattern of the contacts 11 of the connection device, is positioned with each of its terminals in contact with a contact pin of the corresponding contact 11. Test signals can now be coupled through the connection device to the terminals of the printed circuit board.

Further, a connection device, as shown in prior art Fig. 2, is proposed which uses coaxial contacts to improve the transmission characteristics of high-speed signals. In Fig. 2, one contact 21 serving as a center conductor is centered in a hole in an external conductor 20 by a plug 23 of electrical insulating material. The external conductor 20 and another contact 22 are coupled electrically and mechanically. Specifically, such a' coupling means (the external conductor) is a metal block 20. An external conductor 24 in the form of a tube or a pipe of circular cross-section made of copper or the like, is fitted in a cylindrical hole 25 extending through the metal block 20. The cylindrical electrical insulating plug 23 which has small high-frequency loss, is press-fitted in the external conductor 24, and the contact 21 is press-fitted in the cylindrical electrical insulating plug 23. Where needed, a projection (not shown) for preventing the electrical insulating plug 23 from slipping out of the external conductor 24 is created by pressing an intermediate portion of the external conductor 24 inward against the plug 23. The external conductor 24 with the contact 21 held at the center is press-fitted in the cylindrical hole 25, thereby being held by the metal block 20. The metal block 20 has another cylindrical hole 26 therethrough parallel to the hole 25, and the other contact 22 is press-fitted in this hole 26 in electrical contact with the metal block 20.

However, in the case of Fig. 1, a large number of circular holes for receiving the contact probes 11 must be. drilled through the housing 10 with high precision. Also, in the case of the connection device shown in Fig. 2, the circular holes 25 and 26 in the metal block 20 must be drilled with high precision, and the external conductor 24 must be press-fitted in the circular hole 25. These machining and assembling operations are complex and expensive. Where a large number of signals are to be transmitted, this type of fabrication is not cost effective.

## Summary of the Invention

It is an object of the present invention to provide a terminal connection device which has excellent electrical performance and which has a configuration of parts which are easy to manufacture and assemble.

According to one embodiment of the present invention, a metal housing is formed with cylindrical holes through the metal housing. One group of holes is fitted with tubular contacts each serving as an internal conductor, concentrically fitted in tubular electrical insulators or plugs in the one group of holes. Another group of holes each are fitted with a tubular contact which is not electrically insulated from the housing. The metal housing functions as a common external conductor, which may be ground. Individual slots through the outer face of the metal housing are each axially aligned with a hole and open into each hole. The slots are narrower than the holes. Accordingly, so-called extrusion molding is easily applied to the fabrication of the metal housing, so that the metal housing can be fabricated at very low cost. Further, the electrical insulating plug is positioned and secured in the hole by means passing through the slot thereat which is attached to the plug and to a support on an outer adjacent face of the metal housing. This eliminates close tolerance interference fits for securing the internal conductor so that the cost of assembly can also be reduced. Further, if a metalized part or ground pattern or the like of a printed circuit board which is attached to the face of the metal housing, as noted above, is used to close the slot at the housing face at the location of the internal conductor, a coaxial conductor structure is formed by the wall of the hole through the metal housing and the tubular contact serving as the internal conductor, thereby minimizing electrical signal degradation.

## Brief Description of the Drawings

Fig. 1 illustrates one type of prior art connecting device.

Fig. 2 illustrates a connection device having coaxial contact probes, representing a second type of prior art connecting device.

Fig. 3 is a perspective view of a first embodiment of this invention;

Fig. 4 is a plan view of Fig. 1.

Fig. 5 is a sectional view taken on the line V-V of Fig. 4.

Fig. 6a, 6b, and 6c are three views of a coaxial insulator structure for mounting an internal conductor;

Fig. 7 is a perspective view explanatory of the fabrication pieces of the first embodiment of the invention; and

Fig. 8 is a perspective view of a second embodiment of this invention.

## Description of the Preferred Embodiment

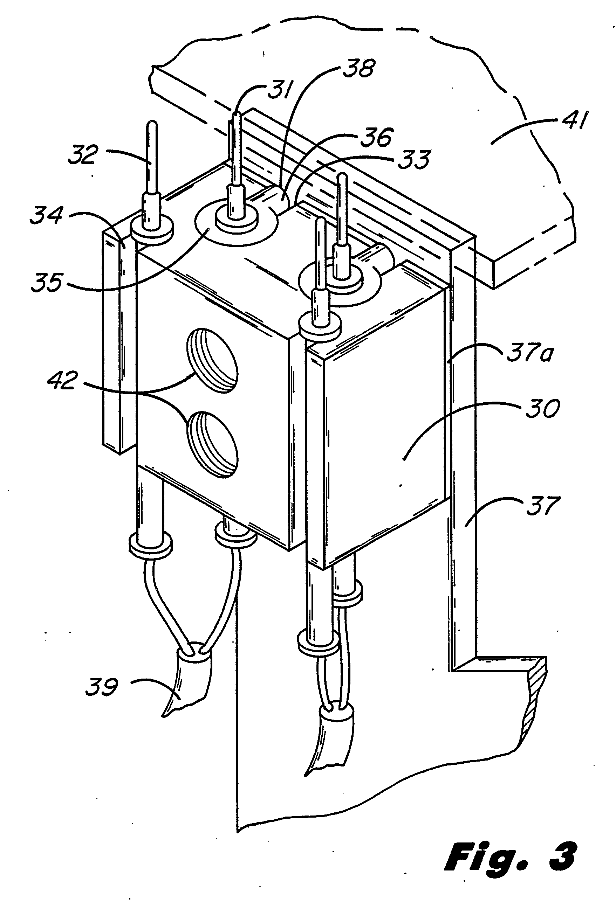

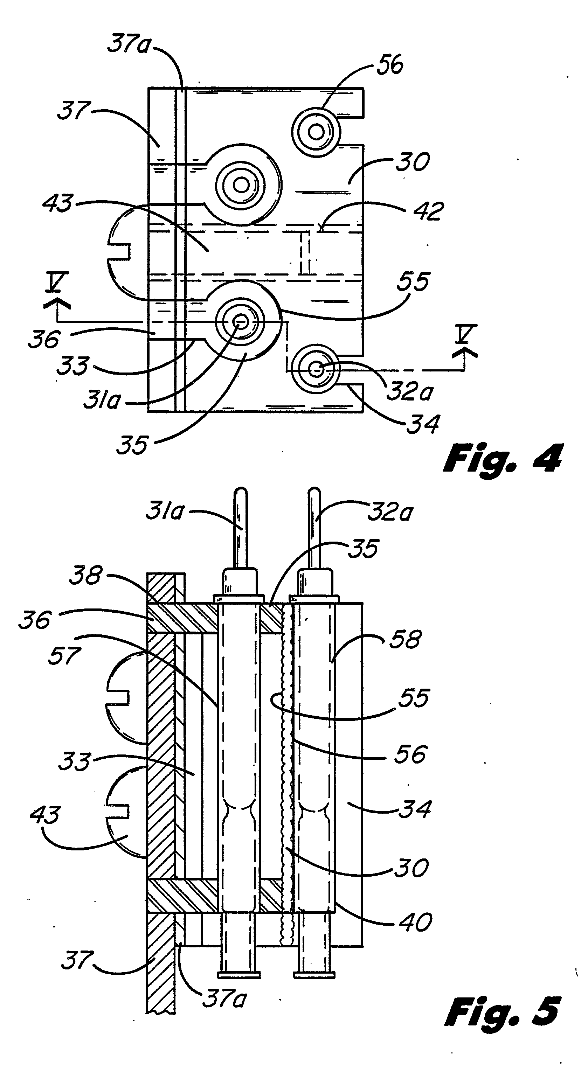

Fig. 3 is a perspective view showing a terminal connection device according to a first embodiment of the present invention. Figs. 4 and 5 are respectively, plan and sectional views of the terminal connection device of Fig. 3. In Figs. 3, 4, 5, a metal housing 30 has a plurality of cylindrical holes 55 and 56 therethrough and as described hereinafter, slots 33 and 34, disposed axially of the holes, extend between the holes and an adjacent surface of the metal housing, which opens the holes through the side of the metal housing. A tubular contact 31, having a spring-loaded retractable contact probe 31a, serving as an internal conductor, is supported concentrically in a cylindrical hole 55 by means of plugs 35 of an electrical insulating material, via a tube 57, Figs. 5, in which the tubular contact 31 is secured. The plugs 35 of electrical insulating material each have a positioning projection 36, and this positioning projection passes through the open end of the slot 33 in the side of the metal housing. The end of this positioning projection 36 is fitted in a positioning hole 38 in a printed circuit board 37 secured to that side of the housing. Another tubular contact 32 having a spring-loaded retractable contact probe 32a, serving as an external conductor, is secured in a tube 58 which is either press-fitted in another cylindrical hole 56 of the metal housing, or secured thereto by brazing, for example.

Each contact probe 31a, 32a is brought into yielding resilient connection, for example, with a corresponding signal pad or grounding pad provided on a printed circuit board 41, Fig. 3. (The contact probe 31a is connected with a signal pad and the contact probe 32a with a grounding pad.) The other end of each tube is connected electrically with coaxial cable 39, Fig. 3, or the like, by soldering, for example.

Although, in the embodiment shown in Fig. 3 four tubular contacts are disposed in one metal housing, with two serving as the internal conductor and the other two serving as the external conductor, the number of pairs of tubular contacts, in which a pair comprises one internal and one external tubular contact, may be of any necessary number and is not limited to two pairs. Alternatively pairs of contacts may not be needed. If the printed circuit board 41 has a common grounding pad or pads for a group of several signal pads, only one external tubular contact may be required for that group.

The printed circuit board 37 is secured to the metal housing 30 by means of screws 43 which thread into tapped holes 42 in the metal housing 30. If one side of the printed circuit board 37 against the metal housing 30 is provided with a metallic conductive layer or pattern 37a large enough to cover at least each slot 33, shielding of the tubular contact 31, which is the internal conductor, is completed. Closing the open end of the slot forms a coaxial conductor in which the tubular contact 31 is the conductor and the inner wall of the cylindrical hole 55 in conjunction with the metallic layer or pattern forms the shield, so that mismatching of impedance around the coaxial conductor structure is minimal. In the alternative, a metal plate may be substituted for the metalized printed circuit board 37.

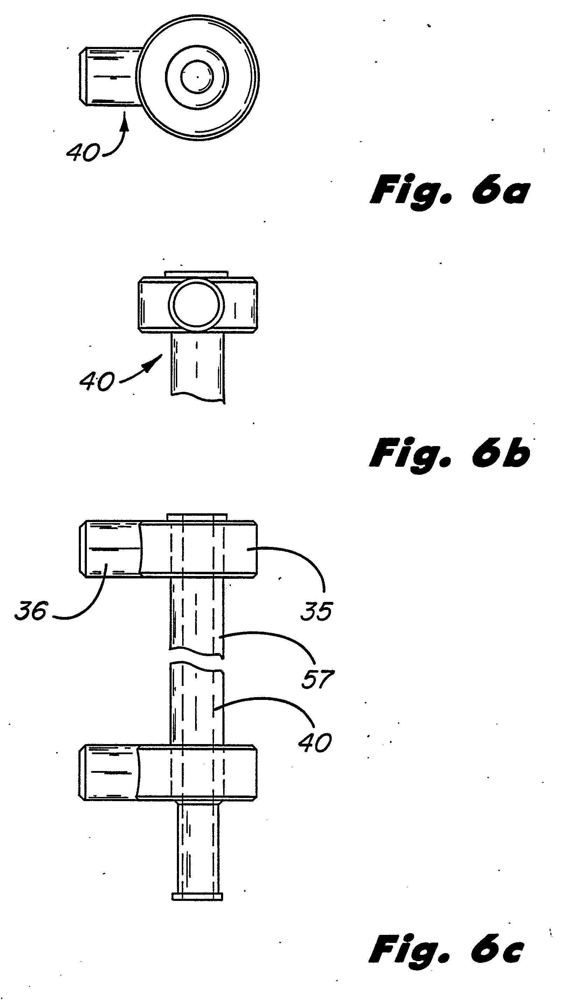

In the embodiment of the invention, as shown in Fig. 5, the tubular contacts 31 and 32 are secured within a tube 57 or 58, respectively. The tubes 57, 58 are of an electrically conductive material and forms part of an integrated member 40 including the electrical insulating plugs 35, as seen in Figs. 6a-6C. This integrated member slides into the hole 55, the projections 36 passing through the slot 33 beyond the face of the metal housing 30. Thereafter the printed circuit board 37 or a metal plate, has its holes aligned with and fitted over the projections 36, after which the board or plate is secured by screws 43. The metal tube 58 is press-fitted or brazed in the hole 56. With this configuration, the tubular contacts can be easily exchanged.

In Figs. 4 and 5, as described above, the electrical insulating plugs 35 are secured in position when the projections 36 are fitted in the positioning holes 38 in the printed circuit board. Thus, smooth insertion of the insulating plugs 35 can be attained if the diameter of the hole 55 is made slightly larger than that of the electrical insulating plug 35. That is, the tube 57 can be positioned in place without the need for preciseness of machining of each hole and each plug diameter to provide an interference fit. Although the metal tube 58 of tubular contact 32, serving as the external conductor may be press-fitted in the hole 56, close tolerance machining can be avoided if a sliding fit in hole 56 is provided. The metal tube 58 is then secured electrically and mechanically to the metal housing by brazing, for example, from outside through the slot 34.

Figs. 6a, 6b and 6c provide additional details. The tube 57 and the insulating plugs 35 can be fabricated very easily if the plugs 35, when being injection-molded are molded integrally with tube 57. The projection 36 is also molded at the same time. Mold complexity is reduced if the plugs 35 are molded separately and cemented over the tube at its ends. The plugs 35 are located at the ends of the tube 57. With this configuration, a large part of the periphery of the tube 57, when installed in the metallic housing 30, is surrounded with air having small high-frequency loss which is desirable.

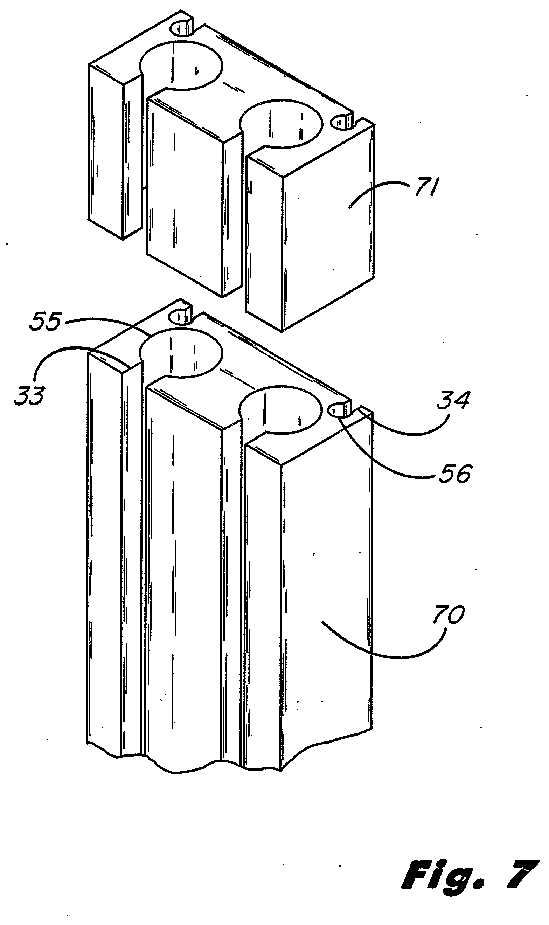

Fig. 7 is useful in explaining the fabrication process of the metal housing in this first embodiment of the invention. If the slots 33 and 34 are included to open the holes 55 and 56 through the adjacent housing faces it is easy to manufacture a die (not shown) for extrusion molding of the metal housing. Thus, the tolerance of the die and the finishing tolerance of an extruded housing are improved, economical precision forming of a long metal housing section is obtained. A metal housing 71 can be fabricated, as shown in Fig. 7, by extruding a long section 70 and then sawing the individual metal housings 71 from the long metal housing section. Thereafter the screw holes are drilled and tapped. Mass production using this process is economical in comparison with the conventional process wherein the metal housing surfaces have been machined and the holes through the metal housing are drilled.

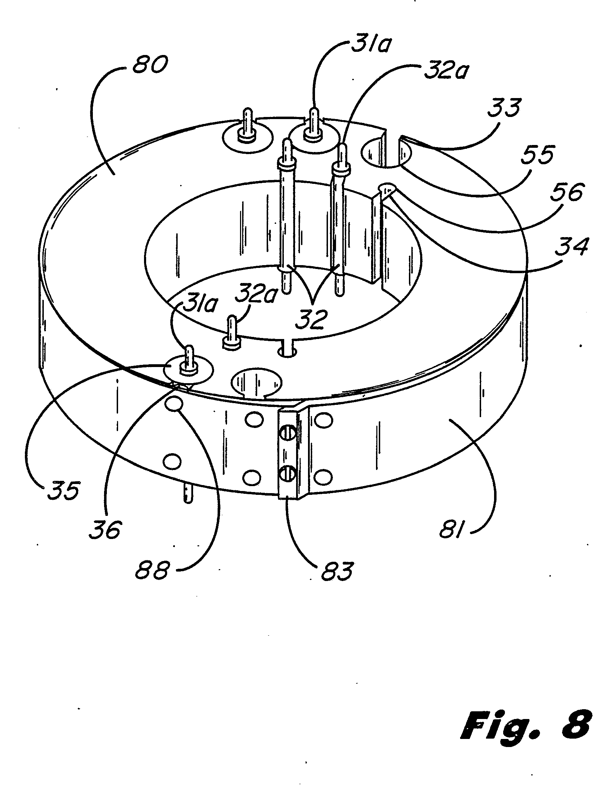

Fig. 8 is a perspective view showing a terminal connection device according to a second embodiment of the present invention. The connection device of this drawing is used, for example, to connect together mutually-parallel printed circuit boards (not shown), which includes tubular contacts disposed in a ring-shaped metal housing 80. In this drawing, the tubular contacts 31 and 32 are employed to achieve the same functions as those of the tubular contacts 31 and 32 of the first embodiment. In the second embodiment, however, both the upper end and the lower ends of each tubular contact 31 and 32 are equipped with spring-loaded contact probes 31a and 32a, respectively. The plugs 35 of electrical insulating material provided around each tubular contact 31 serving as the internal conductor, positioning projection 36, cylindrical holes 55, 56 formed in the metal housing and slits 33, 34 communicating with each hole, are identical in function and structure with those of the first embodiment. The projections 36 of the second embodiment are fitted in positioning holes 88 formed in a band-like metal plate 81 wound around the ring-shaped metal housing 80, whereby the tubular contacts 31, serving as the internal conductor, are mechanically positioned and held via the member 40 having the electrical insulating plugs 35. The band-like metal plate 81 is fixed at appropriate points to the metal housing 80 by screws 83. The band-like metal plate 81 functions also to electrically close the slots 33 and to preserve coaxiality around the tubular contacts 31 serving as the internal conductor. (Fig. 8 shows only a part of the tubular contacts.)

The ring-shaped metal housing of the second embodiment can be easily mass-produced by extrusion molding, similarly to the metal housing of the first embodiment, and can be as easily assembled as the first embodiment.

As described with reference to the first and second embodiments, the structural configuration of the terminal connection device of the present invention allows economical fabrication of the parts of the terminal connection device which can connect a large number of signals at a time without causing degradation of the high-speed signal transmission characteristics.

## Claims

1. A terminal connection device including a plurality of tubular contacts (31,32), each having a retractable projecting contact probe (31a,32a) which is adapted to be pressed against a contact associated with a device under test (41) to transmit a signal comprising:

a. a housing (30) for holding said plurality of tubular contacts (31,32), said housing (30) having a plurality of holes (55,56) therethrough, each hole (55,56) having a slot (33,34) along its length opening through an adjacent surface of said housing (30); and

b. means (40,58) supporting a tubular contact at the center of some of said holes (55,56) with the end of each tubular contact (31,32) projecting from said housing (30).

2. A terminal connection device including a plurality of tubular contacts (31,32), each having a retractable projecting contact probe (31a,32a) which is adapted to be pressed against a contact associated with a device under test (41) to transmit a signal, comprising;

a metal block (30) with a plurality of cylindrical holes (55,56) therethrough, each hole (55,56) having a slot (33,34) paralleling the axis of the hole and opening through an adjacent surface of said metal block (30); and

electrical insulating support means (35,37) positioning said tubular contacts (31) in selected holes (55) of said metal block (30).

3. A terminal connection device as in claim 2, further including electrically conductive material (37a) covering the open end of the slot of each selected hole (55).

4. A terminal connection device as in claim 2, wherein said electrical insulating support means (35,37) comprises separate axially spaced plugs (35) of electrical insulating material in said holes (55) near the ends of said holes (55).

5. A terminal connection device as in claim 3, wherein said electrical insulating support means comprises separate axially spaced plugs (35) of electrical insulating material in said holes (55) near the ends of said holes (55).

6. A terminal connection device as in claim 4, comprising:

a. projections (36) on said plugs (35); and

b. means (37) secured to said metal block (30) for engaging and securing said projections (36) in fixed positions to prevent movement of said plugs.

7. A terminal connection device including a plurality of tubular contacts (31,32), each having a spring-loaded axially movable contact probe (31a or 32a) projecting from one end thereof, which contact probe is adapted to be engaged with a contact associated with a device (41) under test for transferring test signals, comprising:

a. a metallic housing (30) having a plurality of holes (55,56) therethrough, each hole having a slot (33,34) extending its entire length and opening through an adjacent surface of said housing (30);

b. electrical insulating means (35,37) supporting a tubular contact (31) centrally and in noncontacting relationship with the wall of each of a first plurality (55) of said holes.

c. means (58) supporting a tubular contact (32) in electrical contact with said metal housing (30) in each of a second plurality of holes (56); and

d. metallic means (37a) electrically closing the open ends of at least those slots (33) of the first plurality of holes (55).

**Fig. 1**
PRIOR ART

**Fig. 2**
PRIOR ART

**Fig. 3**

**Fig. 4**

**Fig. 5**

*Fig. 6a*

*Fig. 6b*

*Fig. 6c*

Fig. 7

Fig. 8